# FASCICULE DE BREVET EUROPEEN

(11) **EP 4 102 526 B1**
(45) Date de publication et mention de la délivrance du brevet: **28.02.2024**
(21) Numéro de dépôt: 22178222.0
(22) Date de dépôt: 09.06.2022
(51) Int. Cl.: H01G 4/005, H01G 4/012, H01G 4/08, H01G 4/33, H10N 97/00

(54) **DISPOSITIF CAPACITIF A HAUTE DENSITE AYANT DES ZONES D'ISOLATION BIEN DEFINIES**
KAPAZITIVE VORRICHTUNG MIT HOHER DICHTE, DIE ÜBER KLAR DEFINIERTE ISOLATIONSZONEN VERFÜGT
HIGH DENSITY CAPACITIVE DEVICE WITH WELL DEFINED INSULATED AREAS

(30) Priorité: 10.06.2021 FR 2106145
(43) Date de publication de la demande: 14.12.2022
(73) Titulaire: Commissariat à l'énergie atomique et aux énergies alternatives, 75015 Paris (FR)
(72) Inventeur: CLARET, Thierry, 38054 GRENOBLE CEDEX 09 (FR); FERREIRA, Delphine, 38054 GRENOBLE CEDEX 09 (FR); RAMOS, Raphael, 38054 GRENOBLE CEDEX 09 (FR)
(74) Mandataire: Brevalex

(56) Documents cités:
- EP-A1- 3 795 721
- WO-A1-2021/059570
- US-A1- 2006 214 262
- US-A1- 2008 197 399
- US-A1- 2009 035 513
- US-A1- 2015 200 058
- JINGNAN SONG ET AL: "Fast Growth of Highly Ordered TiO2 Nanotube Arrays on Si Substrate under High-Field Anodization", NANO-MICRO LETTERS, vol. 9, no. 2, 9 novembre 2016 (2016-11-09), XP055745034, ISSN: 2311-6706, DOI: 10.1007/s40820-016-0114-4
- JEONG S-H ET AL: "PACKING DENSITY CONTROL OF ALIGNED CARBON NANOTUBES", CHEMISTRY OF MATERIALS, AMERICAN CHEMICAL SOCIETY, US, vol. 14, no. 10, 1 octobre 2002 (2002-10-01), pages 4003-4005, XP001502062, ISSN: 0897-4756, DOI: 10.1021/CM020302V

## Description

### DOMAINE TECHNIQUE

La présente invention se rapporte au domaine général des dispositifs capacitifs.

L'invention concerne un procédé de fabrication d'un dispositif capacitif à haute densité, réalisé sur une structure à fort facteur de forme présentant des zones d'isolation améliorées.

L'invention concerne également un dispositif capacitif ainsi obtenu.

L'invention est particulièrement intéressante puisqu'elle permet d'obtenir un dispositif capacitif à haute densité (plus de 1µF/mm²) présentant une bonne compacité et une bonne délimitation de l'électrode inférieure et de l'électrode supérieure dans l'espace.

L'invention trouve des applications dans de nombreux domaines industriels, et notamment pour la fabrication de composants passifs et pour l'intégration 3D.

### ÉTAT DE LA TECHNIQUE ANTÉRIEURE

Les capacités à haute densité font aujourd'hui l'objet d'intenses développements. Ces capacités comprennent notamment un empilement, dit empilement capacitif, pourvu de deux ou trois couches, et formé sur une surface ou une structure présentant un facteur de forme élevé afin de limiter l'encombrement de ces capacités. EP 3 795 721 A1 divulgue un procédé de fabrication d'un dispositif capacitif.

Parmi les dispositifs capacitifs les plus aboutis, on peut citer ceux obtenus avec un dépôt Métal/Isolant/Métal (MIM) sur la surface déployée d'une matrice d'alumine poreuse (structure fermée). Ce type de dépôt couche mince conforme malgré les forts aspects ratios est réalisé par dépôt de couches atomiques (ou ALD pour « Atomic Layer Déposition »), dans des réacteurs avec un mode « exposition ». La zone capacitive est définie généralement par une ouverture dans un masque dur. Des capacités à haute densité (de l'ordre de 1µF/mm²) avec des tensions de claquage de quelques volts peuvent être obtenues. Ces dispositifs commencent à alimenter les marchés.

La même technologie de dépôt par ALD peut être mise en oeuvre pour réaliser des capacités haute densité avec des structures ouvertes de type piliers (nanotubes ou nanofils notamment). Les nanofils ou les nanotubes, et plus particulièrement les nanotubes de carbone (NTC), qui présentent un rapport surface/volume important, sont des candidats de choix pour la réalisation de ces structures ouvertes à facteur de forme élevé. Nous citerons, à titre d'exemple, les piliers obtenus par gravure (tripodes Si), les tresses de Nano-Tubes de Carbone (NTC) et les tubes d'autres natures obtenus par croissance (tubes de TiN par exemple), les fils (colonnes de Ni par exemple) obtenus par dépôt électrolytique (« Electrolytic Chemical Déposition » ou ECD) à travers une matrice poreuse éliminée chimiquement par la suite. Cette technologie à base de NTC ou des nanofils permet la reprise de contact pour des composants RF (> GHz). Cependant, les dépôts ALD peuvent se développer sous le masque à travers la structure 3D ouverte, ce qui conduit à une zone capacitive mal délimitée.

Pour pallier ce phénomène, des zones de gravure avec de forte topologie doivent être mises en oeuvre. En effet, la technologie des capacités à base de NTC peut engendrer, par exemple, une topologie de plusieurs dizaines de microns.

A ce jour, la délimitation de la capacité à une zone bien définie et le traitement de l'isolation des dispositifs capacitifs à haute densité ne sont pas abordés pour des structures ouvertes de type nanopiliers.

### EXPOSÉ DE L'INVENTION

Un but de la présente invention est de proposer un procédé remédiant aux inconvénients de l'art antérieur et permettant d'obtenir un dispositif capacitif à haute densité, présentant une bonne isolation de l'électrode inférieure et une zone capacitive bien délimitée, le procédé devant être simple à mettre en oeuvre.

Pour cela, la présente invention propose un procédé de fabrication d'un dispositif capacitif comprenant les étapes suivantes :
i) fournir un substrat comprenant :
   - une première zone en un premier matériau et/ou ayant une première texturation,
   - une deuxième zone en un deuxième matériau et/ou ayant une deuxième texturation,
   - une troisième zone en un troisième matériau et/ou ayant une troisième texturation,
      le premier matériau étant différent du troisième matériau et/ou la première texturation étant différente de la troisième texturation,
      le premier matériau pouvant être identique ou différent du deuxième matériau et/ou la première texturation pouvant être identique ou différente de la deuxième texturation,
ii) faire croître des nanopiliers, de préférence des nanotubes de carbone ou des nanofils métalliques, sur le substrat, moyennant quoi on obtient une couche de nanopiliers présentant localement différentes densités, les nanopiliers au niveau de la première zone ayant une première densité, les nanopiliers au niveau de la deuxième zone ayant une deuxième densité, les nanopiliers au niveau de la troisième zone ayant une troisième densité, la première densité étant inférieure à la troisième densité, la première densité pouvant être identique ou différente de la deuxième densité,
iii) déposer une couche isolante sur la couche de nanopiliers, la couche isolante recouvrant de manière conforme et continue les nanopiliers au moins au niveau de la première zone,
iv) déposer une couche conductrice, sur la couche de nanopiliers, la couche conductrice recouvrant de manière conforme et continue la couche isolante au moins au niveau de la première zone, moyennant quoi on forme un empilement capacitif au niveau de la première zone, l'empilement capacitif comprenant la couche isolante et la couche conductrice.

L'invention se distingue fondamentalement de l'art antérieur par la mise en oeuvre d'un substrat particulier pour former une structure ouverte formée d'une couche de nanopiliers ayant localement différentes densités (c'est-à-dire différents espaces inter-nanopiliers). En particulier, au niveau de la zone capacitive (1^{ère} zone), les nanopiliers présentent une faible densité (i.e. ils sont espacés) permettant le dépôt de l'empilement capacitif. Au niveau de la zone d'isolation de l'électrode supérieure (3^{ème} zone), les nanopiliers présentent une forte densité (i.e. ils sont serrés), empêchant le dépôt de la couche conductrice ou sa progression latérale sous un masque le cas échéant.

Selon une première variante de réalisation avantageuse, les étapes iii) et iv) sont réalisées en déposant la couche isolante et la couche conductrice pleine plaque, la couche isolante et la couche conductrice recouvrant de manière conforme la couche de nanopiliers au niveau de la première zone et au niveau de la deuxième zone, de manière à former une reprise de contact au niveau de la deuxième zone, la couche isolante bouchant l'espace entre les nanopiliers au niveau de la troisième zone, moyennant quoi on forme une zone d'isolation électrique.

Selon une deuxième variante de réalisation avantageuse, entre les étapes iii) et iv), le procédé comporte une étape au cours de laquelle on forme un masque sur la couche de nanopiliers au niveau de la troisième zone. Lors du dépôt des couches de l'empilement capacitif, le masque protège la troisième zone. De plus, comme les nanopiliers ont une plus forte densité au niveau de la troisième zone, cela conduit à un arrêt de la progression latérale des dépôts ALD au niveau de cette zone d'isolation.

Selon cette deuxième variante de réalisation, le masque peut, avantageusement, recouvrir la couche de nanopiliers à la fois au niveau de la deuxième zone et au niveau de la troisième zone.

L'empilement capacitif peut être constitué de la couche isolante et de la couche conductrice (empilement isolant/métal ou IM).

Alternativement, le procédé peut comporter une étape additionnelle, entre l'étape ii) et l'étape iii), au cours de laquelle on dépose une couche conductrice additionnelle, l'empilement capacitif de la première zone comprenant la couche conductrice additionnelle, la couche isolante et la couche conductrice. Autrement dit, on forme un empilement métal/isolant/métal (empilement MIM).

Avantageusement, au niveau de la première zone et/ou au niveau de la deuxième zone, l'espacement entre les nanopiliers est compris entre 60 nm et 140 nm.

Avantageusement, au niveau de la troisième zone, l'espacement entre les nanopiliers est compris entre 10 nm et 20 nm.

Selon une variante de réalisation avantageuse, le substrat fourni à l'étape i) comprend une couche principale en aluminium recouverte par une couche d'oxyde, par exemple en oxyde d'aluminium, ayant des ouvertures traversantes débouchant sur la couche principale en aluminium, une première ouverture traversante correspondant à la première zone et une deuxième ouverture traversante correspondant à la deuxième zone, une partie de la couche d'oxyde disposée entre la première zone et la deuxième zone correspondant à la troisième zone.

Selon une autre variante de réalisation avantageuse, le substrat fourni à l'étape i) comprend une couche principale en aluminium recouverte par un premier catalyseur et par un deuxième catalyseur, la première zone et la deuxième zone étant formées au niveau du premier catalyseur et la troisième zone étant formée au niveau du deuxième catalyseur.

Selon une autre variante de réalisation avantageuse le substrat fourni à l'étape i) est obtenu selon les étapes suivantes :
a) fournir un substrat comprenant une couche principale en aluminium,
b) structurer localement une première partie de la couche principale d'aluminium par un premier procédé d'anodisation, de manière à définir une première zone,
c) structurer localement une deuxième partie de la couche principale d'aluminium par un deuxième procédé d'anodisation, de manière à définir une deuxième zone,
d) structurer localement une troisième partie de la couche principale d'aluminium par un troisième procédé d'anodisation, de manière à définir une troisième zone,
e) réaliser une étape de gravure,

moyennant quoi on obtient une couche principale d'aluminium structurée comprenant une première structuration au niveau de la première zone, une deuxième structuration au niveau de la deuxième zone et une troisième structuration au niveau de la troisième zone,
la première structuration étant différente de la troisième structuration,
la première structuration étant identique ou différente de la deuxième structuration.

Les différents procédés d'anodisation peuvent être réalisés à des potentiels et/ou avec des durées différentes conduisant à la formation d'une couche d'alumine.

On réalisera, avantageusement, une seule étape de gravure pour retirer l'alumine formée. Alternativement, il est possible de retirer l'alumine formée après chaque étape d'anodisation.

Avantageusement, le substrat repose sur un support comprenant une couche diélectrique, de préférence en oxyde de silicium, une tranchée étant formée à travers le substrat jusqu'à la couche diélectrique recouvrant le support, la tranchée formant une quatrième zone. Lors de l'étape ii) on fait croître des nanopiliers au niveau de la quatrième zone, les nanopiliers ayant une quatrième densité, la quatrième densité étant supérieure à la première densité et à la deuxième densité. La tranchée peut servir de zone de séparation des dispositifs, de chemins de découpe ou pour dissocier l'électrode inférieure.

Avantageusement, le procédé comporte, en outre, une ou plusieurs des étapes suivantes :
- former une électrode supérieure sur la zone capacitive,
- former une reprise de contact au niveau de la deuxième zone,
- former une électrode inférieure sur la reprise de contact,
- séparer les dispositifs capacitifs formés sur un même substrat au niveau des tranchées.

Le procédé présente de nombreux avantages :
- un tel agencement permet de simplifier l'empilement technologique,
- les couches de l'empilement capacitif peuvent être déposées pleine plaque, sans utiliser de masque, ce qui simplifie le procédé de fabrication, et réduit les coûts de fabrication,
- lorsque des masques sont utilisés, il y a un arrêt de la progression latérale des couches déposées par ALD, grâce aux différentes densités des nanopiliers,
- la topologie est maîtrisée,
- une optimisation de l'implantation,
- permettre une reprise de contact idéale pour des dispositifs RF,
- il n'y a pas besoin de gravure, pour former la zone capacitive, la zone de reprise de contact et la zone d'isolation,
- une facilité de procédé pour isoler l'électrode inférieure malgré la forte topologie.

L'invention concerne également un dispositif capacitif à haute densité, obtenu selon le procédé précédemment décrit, comprenant :
- un substrat comprenant :
- une première zone en un premier matériau et/ou ayant une première texturation,
- une deuxième zone en un deuxième matériau et/ou ayant une deuxième texturation,
- une troisième zone en un troisième matériau et/ou ayant une troisième texturation,
   le premier matériau étant différent du troisième matériau et/ou la première texturation étant différente de la troisième texturation,
   le premier matériau pouvant être identique ou différent du deuxième matériau et/ou la première texturation pouvant être identique ou différente de la deuxième texturation,
- une couche de nanopiliers, de préférence des nanotubes de carbone ou des nanofils métalliques, recouvrant le substrat et présentant localement différentes densités, les nanopiliers au niveau de la première zone ayant une première densité, les nanopiliers au niveau de la deuxième zone ayant une deuxième densité, les nanopiliers au niveau de la troisième zone ayant une troisième densité, la première densité étant inférieure à la troisième densité, la première densité pouvant être identique ou différente de la deuxième densité,
- un empilement capacitif recouvrant de manière conforme et continue les nanopiliers, au niveau de la première zone, de manière à former une zone capacitive, l'empilement capacitif comprenant la couche isolante et la couche conductrice, et éventuellement une couche conductrice additionnelle disposée entre les nanopiliers et la couche isolante.

L'empilement capacitif comprend, par exemple, une couche conductrice en TiN, une couche isolante en Al₂O₃, et éventuellement une couche conductrice additionnelle en TiN, disposée entre la couche isolante et les nanopiliers.

L'invention se distingue fondamentalement de l'art antérieur par la présence d'une couche de nanopiliers présentant localement différentes densités.

Le dispositif capacitif présente une topologie plus maitrisée, et surtout une implantation optimisée. Le dispositif comprend également une reprise de contact au niveau de la deuxième zone. Il s'agit d'un élément électriquement conducteur remplissant partiellement ou totalement l'espace entre les nanopiliers au niveau de la deuxième zone.

Avantageusement, la reprise de contact est formée d'un empilement capacitif identique à l'empilement capacitif de la première zone. L'empilement capacitif recouvre de manière conforme et continue les nanopiliers au niveau de la deuxième zone.

Une telle reprise de contact de l'électrode inférieure permet d'envisager des composants RF fonctionnant au-delà du GHz.

La configuration et/ou l'agencement d'un tel dispositif capacitif permet de conférer à ce dernier une meilleure compacité au regard des dispositifs connus de l'état de la technique.

Avantageusement, la couche isolante remplit complètement l'espace entre les nanopiliers au niveau de la troisième zone, moyennant quoi on forme une zone d'isolation entre la zone capacitive et la zone de reprise de contact.

Avantageusement, le substrat repose sur un support comprenant une couche diélectrique, de préférence une couche d'oxyde de silicium, une tranchée étant formée à travers le substrat jusqu'à la couche diélectrique recouvrant le support, la tranchée formant une quatrième zone. De manière encore plus avantageuse, des nanopiliers ayant une quatrième densité remplissent la tranchée, la quatrième densité étant supérieure à la première densité et à la deuxième densité.

Avantageusement, le dispositif comprend, en outre, un ou plusieurs des éléments suivants :
- une électrode supérieure recouvrant la zone capacitive,
- une électrode inférieure recouvrant la reprise de contact.

Ainsi, la structure capacitive obtenue comporte :
- une structure ouverte de nanopiliers, ayant un fort facteur de forme et présentant localement différents espaces inter-piliers, disposée sur le substrat,
- un substrat, relié électriquement à l'électrode inférieure,
- une zone capacitive, formée d'une première zone (ou partie) de la structure ouverte de nanopiliers recouverte de manière conforme et continue par un empilement capacitif, bi-couche IM ou tricouche MIM,
- une zone de reprise de contact BF et/ou RF disposée au niveau d'une deuxième zone (ou partie) de la structure ouverte de nanopiliers, et formée grâce à un dépôt de matériau conducteur entre les nanopiliers, le dépôt pouvant éventuellement remplir complètement l'espace entre les nanopiliers.

Le dispositif présente de nombreux avantages :
- l'utilisation d'un dépôt de type ALD permet d'obtenir une couche mince, de maximiser la
   capacité,
- toute la zone capacitive peut être utilisée,
- une bonne isolation de l'électrode inférieure et une zone capacitive bien délimitée,
- la structure ouverte de nanopiliers est, avantageusement, utilisée pour connecter l'électrode inférieure,
- la zone de séparation permet une isolation de l'électrode inférieure de chaque dispositif et/ou la formation de chemins de découpe.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
Les figures 1A à 1D représentent, de manière schématique et en trois dimensions, différentes étapes d'un procédé de fabrication d'un dispositif capacitif selon un mode de réalisation particulier de l'invention.
Les figures 2A à 2E représentent de manière schématique différentes étapes d'un procédé de fabrication d'un dispositif capacitif selon un autre mode de réalisation particulier de l'invention - les inserts de la figure 2C représentent, de manière schématique et en coupe, les couches déposées sur les nanopiliers au niveau des zones Z1, Z2, Z3 et Z4.
Les figures 3A à 3F représentent de manière schématique différentes étapes d'un procédé de fabrication d'un dispositif capacitif selon un autre mode de réalisation particulier de l'invention.

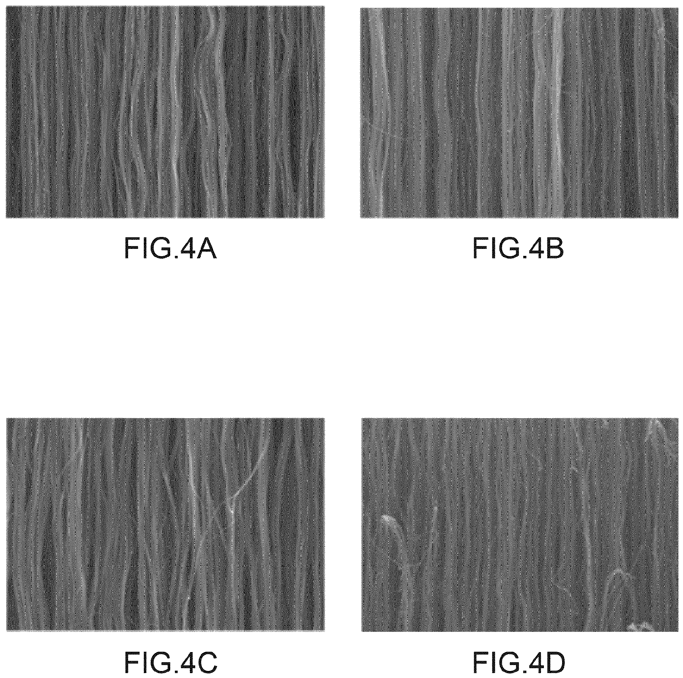

Les figures 4A à 4D sont des clichés obtenus au microscope électronique à balayage de nanopiliers (nanotubes de carbone) obtenus sur différents substrats ayant différentes structurations, selon différents modes de réalisation de l'invention, respectivement sur un substrat en aluminium anodisé à 60V recouvert d'une couche catalytique en fer, sur un substrat en aluminium anodisé à 90V recouvert d'une couche catalytique en fer, sur un substrat plan en alumine recouvert par une couche catalytique en fer, sur un substrat plan en alumine recouvert par un empilement catalytique Fe/Ti/AI/Fe ; la barre d'échelle correspond à 20µm.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », « sur », « dessous », « sous », etc. d'une structure s'appliquent en considérant que la structure est orientée de la façon illustrée sur les figures.

### EXPOSÉ DÉTAILLÉ DE MODES DE RÉALISATION PARTICULIERS

Bien que cela ne soit aucunement limitatif, l'invention trouve particulièrement des applications dans le domaine des capacités haute densité de plus de 1µF/mm². Le dispositif capacitif pourra avantageusement être intégré dans une structure comprenant d'autres composants.

Le principe du procédé de fabrication d'un dispositif capacitif selon l'invention consiste à générer une structure ouverte comprenant des nanopiliers ayant différentes densités, chaque zone d'une densité particulière correspondant à une zone fonctionnelle du dispositif capacitif. Notamment, les zones présentant un espace inter-pilier libre important peuvent correspondre :
* aux zones capacitives Z1, où l'espace sera suffisant pour déposer par ALD un empilement capacitif de type métal/isolant (IM) ou métal/isolant/métal (MIM),
* aux zones de reprise de contact Z2, où l'espace inter-piliers sera, avantageusement, similaire à ceux des zones capacitives,

Les zones présentant un espace inter-pilier libre limité où :
- le premier dépôt (dans le cas d'un empilement capacitif IM), ou
- les deux premiers dépôts (dans le cas d'un empilement capacitif MIM) satureront les espaces interpiliers empêchant le dépôt du métal conducteur de l'électrode supérieure.

Ces zones peuvent correspondre :
* aux zones d'isolation Z3 (aussi appelée zone neutre) entre les zones capacitives et celles de reprise de contact,
* aux zones de séparation Z4 des électrodes inférieures des différents dispositifs générés sur le substrat, formant des chemins de découpe.

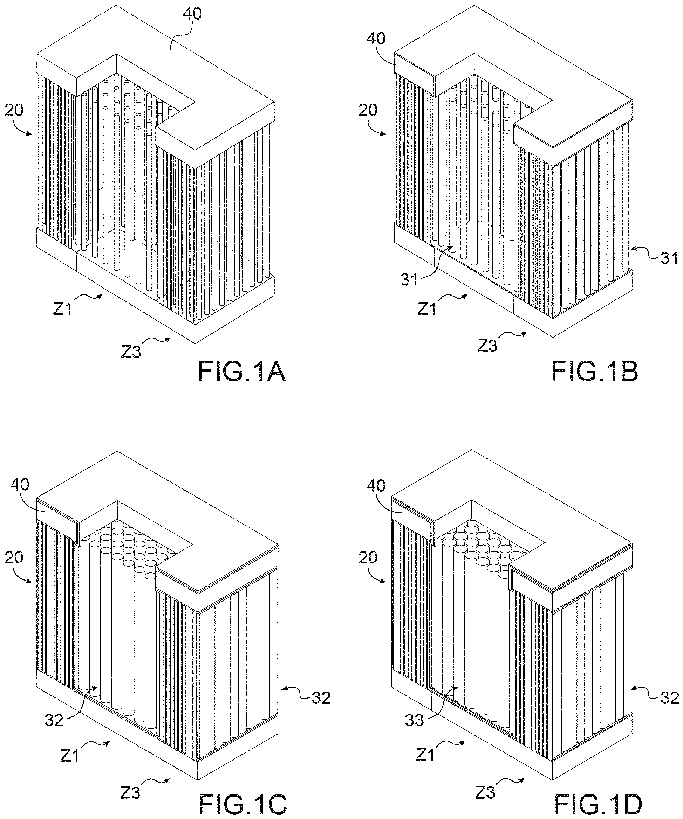

A titre illustratif, la figure 1A représente un substrat 10 recouvert par une couche 20 de nanopiliers (par exemple, des nanotubes de carbone) ayant une première densité au niveau de la zone capacitive Z1 et ayant une autre densité au niveau de la zone d'isolation Z3. La densité des NTC de la zone capacitive Z1 est inférieure à la densité des NTC de la zone d'isolation Z3. La zone d'isolation Z3 est recouverte par un masque 40.

On forme ensuite un empilement capacitif 30 de type MIM par ALD en déposant successivement :
- une première couche métallique 31 : le dépôt métallique recouvre les NTC de la première zone et progresse sous le masque dur (figure 1B),
- une couche isolante 32 : le dépôt métallique recouvre les NTC de la première zone et la partie de la structure de NTC de plus forte densité (2^{ème} zone) est saturée (figure 1C),
- une autre couche métallique 33 : le dépôt est limité à la zone de faible densité (1^{ère} zone), il n'y a pas de progression latérale du dépôt ALD sous le masque (figure 1D).

Selon une variante de réalisation avantageuse, il est possible de ne pas utiliser de masque 40 puisque la structure ouverte de la zone d'isolation Z3 est saturée après le dépôt de la couche isolante. On obtiendra uniquement l'empilement capacitif 30 complet MIM au niveau de la zone capacitive Z1.

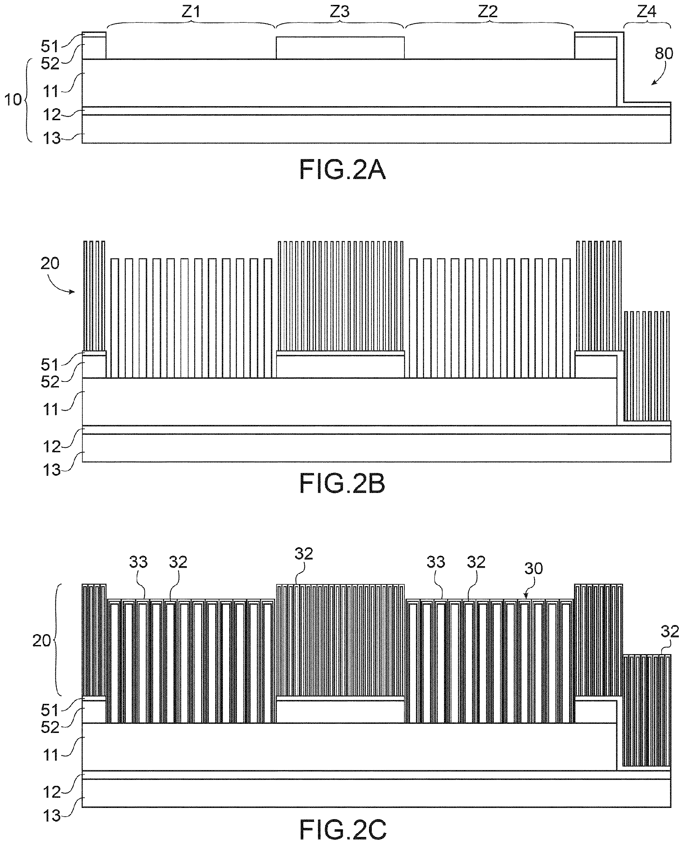

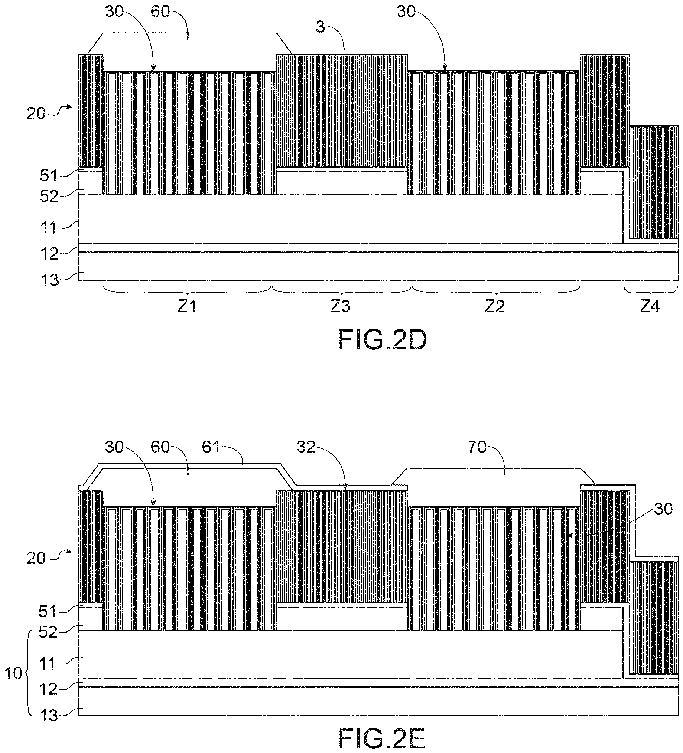

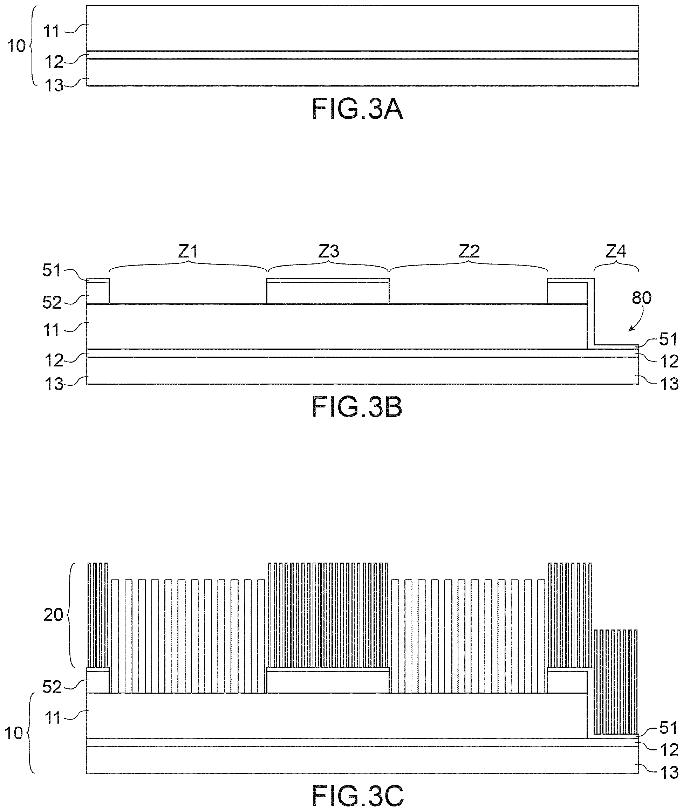

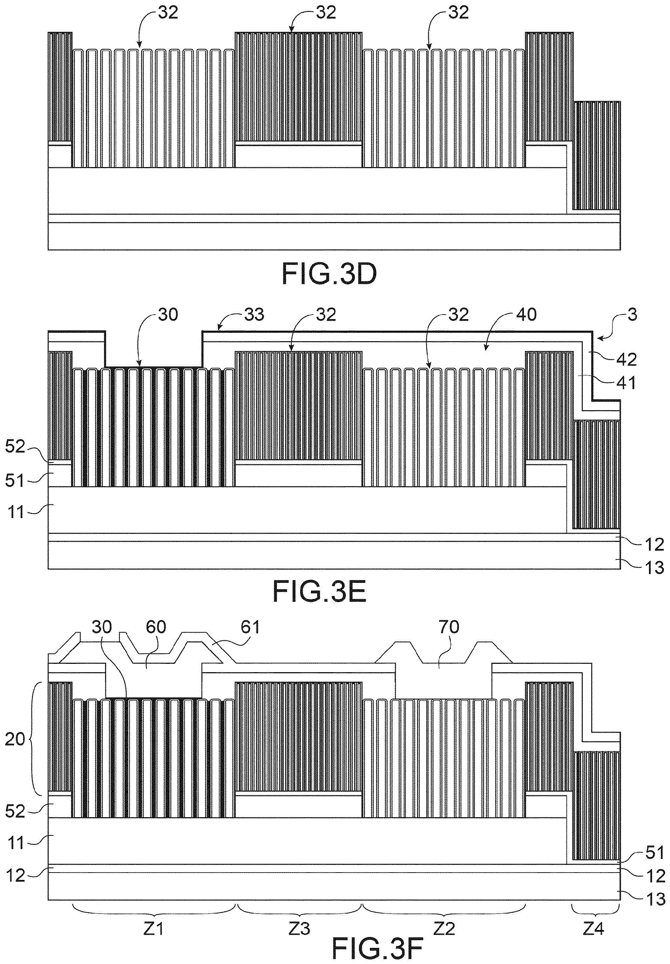

Nous allons maintenant décrire plus en détail deux procédés de fabrication d'un dispositif capacitif selon l'invention en faisant référence aux figures 2A à 2E ou aux figures 3A à 3F. Ces procédés comprennent au moins les étapes suivantes :
i) fournir un substrat 10 comprenant :
   - une première zone Z1 en un premier matériau et/ou ayant une première texturation,
   - une deuxième zone Z2 en un deuxième matériau et/ou ayant une deuxième texturation,
   - une troisième zone Z3 en un troisième matériau et/ou ayant une troisième texturation,
      le premier matériau étant différent du troisième matériau et/ou la première texturation étant différente de la troisième texturation,
      le premier matériau pouvant être identique ou différent du deuxième matériau et/ou la première texturation pouvant être identique ou différente de la deuxième texturation (figure 2A et figure 3B),
ii) faire croître des nanopiliers, de préférence des nanotubes de carbone ou des nanofils métalliques, sur le substrat, moyennant quoi on obtient une couche 20 de nanopiliers présentant localement différentes densités, les nanopiliers au niveau de la première zone Z1 ayant une première densité, les nanopiliers au niveau de la deuxième zone Z2 ayant une deuxième densité, les nanopiliers au niveau de la troisième zone Z3 ayant une troisième densité, la première et la deuxième densités étant inférieures à la troisième densité, la première densité pouvant être identique ou différente de la deuxième densité (figure 2B et figure 3C),
iii) déposer une couche isolante 32 sur la couche de nanopiliers 20, la couche isolante 32 recouvrant de manière conforme et continue les nanopiliers au moins au niveau de la première zone Z1 (figure 3D), et
iv) déposer une couche conductrice 33, sur la couche de nanopiliers 20, la couche conductrice 33 recouvrant de manière conforme et continue la couche isolante 32 au moins au niveau de la première zone Z1, moyennant quoi on forme un empilement capacitif 30 au niveau de la première zone Z1, l'empilement capacitif comprenant la couche isolante 32 et la couche conductrice 33, et une reprise de contact au niveau de la deuxième zone Z2 (aussi appelée zone de reprise de contact) (figure 2C et figure 3E),
v) former une électrode supérieure 60 sur la première zone Z1 (figure 2D),
vi) former une électrode inférieure 70 sur la zone de reprise de contact (figure 2E, figure 3F).

Selon une première variante de réalisation, les étapes iii) et iv) peuvent être réalisées en déposant la couche isolante 32 et la couche conductrice 33 pleine plaque : la couche isolante 32 et la couche conductrice 33 recouvrent de manière conforme la couche de nanopiliers 20 au niveau de la première zone Z1 et au niveau de la deuxième zone Z2, de manière à former, respectivement une zone capacitive et une zone de reprise de contact. La couche isolante 32 bouche l'espace entre les nanopiliers au niveau de la troisième zone Z3, moyennant quoi on forme une zone d'isolation électrique Z3 (figure 2C).

Selon une autre variante de réalisation non représentée, entre les étapes iii) et iv), le procédé peut comporter une étape au cours de laquelle on forme un masque sur la couche de nanopiliers 20 au niveau de la troisième zone Z3 pour la protéger lors du dépôt de l'empilement capacitif.

Selon une autre variante de réalisation, entre les étapes iii) et iv), le procédé peut comporter une étape au cours de laquelle on forme un masque 40 sur la couche de nanopiliers 20 au niveau de la troisième zone Z3 et au niveau de la deuxième zone Z2 (figure3E).

Le substrat 10 fourni à l'étape i) comprend une face avant et une face arrière opposée et essentiellement parallèle à la face avant. Le substrat 10 comprend avantageusement plusieurs couches.

De préférence, le substrat comprend une couche principale 11. La couche principale est, avantageusement, en métal et de préférence en aluminium. La couche principale 11 peut présenter une épaisseur comprise entre 0,5 µm et 5 µm.

La couche principale 11 peut être en contact avec une couche diélectrique 12, notamment une couche d'oxyde. La couche diélectrique 12 peut reposer sur un support 13. La couche diélectrique 12 est ainsi intercalée entre le support 13 et la couche principale 11 (figure 2A et 3B). Autrement, la couche principale 11 peut être déposée directement sur le support 13.

Le support 13 est, par exemple, un substrat de silicium. L'épaisseur du support 13 est par exemple de 725µm.

La couche diélectrique 12 est, par exemple, une couche d'oxyde de silicium. L'épaisseur de la couche diélectrique 12 est par exemple de 0,5µm.

La couche principale 11 peut être formée sur le support 13 ou sur la couche diélectrique 12 par une technique de dépôt ou d'évaporation. La couche principale 11 est, avantageusement, déposée pleine plaque.

A partir de ce substrat 10, on peut former des zones de texturations différentes (par exemple de différentes rugosités) et/ou des zones de natures différentes permettant de faire croître des nanopiliers ayant pour chaque zone une densité particulière.

Par exemple, il est possible de faire croître les nanopiliers sur :
- un substrat en un même matériau présentant localement différentes texturations, ou
- un substrat présentant localement des zones en différents matériaux, ayant la même texturation, ou
- un substrat présentant localement des zones en différents matériaux, ayant différentes texturations.

Avantageusement, le catalyseur utilisé pour la croissance des nanopiliers est le même sur les différentes zones. Alternativement, plusieurs catalyseurs peuvent être utilisés moyennant la mise en oeuvre d'étapes de localisation du catalyseur (masquage, retrait ('lift-off'), etc).

Selon un mode de réalisation avantageux, la couche principale 11 du substrat 10 est texturée (figure 3A). Pour texturer une couche principale 11 métallique, on pourra par exemple réaliser successivement une étape d'anodisation puis une étape de gravure.

La couche principale 11 est, avantageusement, anodisée de manière à former une couche superficielle d'oxyde. Dans le cas d'une couche principale 11 en aluminium, on forme une couche d'oxyde d'aluminium (Al₂O₃ aussi appelée alumine).

Puis la couche d'oxyde formée est gravée de manière à révéler la texturation à la surface de la couche principale 11 due à l'anodisation.

L'anodisation est un procédé électrolytique se déroulant en milieu humide. Le principe repose sur l'application d'une différence de potentiel imposée entre deux électrodes conductrices plongées dans une solution électrolytique qui peut par exemple être l'acide oxalique ou phosphorique. L'application d'un potentiel à l'anode, induit une croissance d'alumine à sa surface, si l'électrode est en aluminium, et une texturation de l'aluminium. La dissolution de l'alumine dans le bain d'acide révèle une texturation à la surface du métal.

Pour la gravure, on choisira, généralement, des solutions d'acide faible tamponnée.

Avantageusement, ces étapes sont réalisées pleine plaque. Il n'y a pas besoin de masque. On obtient ainsi une couche principale 11 d'aluminium ayant, en face avant, une surface préformée organisée (figure 3A).

La couche principale 11 peut présenter une même texturation.

Selon un autre mode de réalisation, la couche principale 11 peut présenter localement des texturations différentes. Par exemple, il est possible de réaliser localement différentes anodisations à travers différents masques, de manière à former différentes texturations dans la couche principale 11. Par exemple, on réalisera localement :
- une première anodisation sur une première partie de la couche principale 11 à un premier potentiel (par exemple 90V) pour former la première zone Z1,
- une deuxième anodisation sur une deuxième partie de la couche principale 11 à un deuxième potentiel pour former une deuxième zone Z2, et
- une troisième anodisation sur une troisième partie de la couche principale 11 à un troisième potentiel (par exemple 60V), le troisième potentiel étant inférieur au premier potentiel, pour former une troisième zone Z3.

Une étape de gravure ultérieure permettra de retirer la couche d'oxyde 14 formée, moyennant quoi on obtient une couche principale 11 comprenant une première structuration au niveau de la première zone et une deuxième structuration au niveau de la deuxième zone et une troisième structuration au niveau de la troisième zone. La première structuration est différente de la troisième structuration. La première structuration est identique ou différente de la deuxième structuration. De préférence, la première structuration est identique à celle de la deuxième structuration et la première anodisation et la deuxième anodisation sont réalisées au cours d'une même étape.

Il est possible de faire croître les nanopiliers directement sur la couche principale localement texturée.

Alternativement, il est possible de ne pas texturer la couche principale 11 et de former localement sur cette couche des zones en différents matériaux.

Selon une autre alternative, il est possible de texturer (localement ou pleine plaque) la couche principale 11 et de former localement sur cette couche principale 11 des zones en différents matériaux.

Selon un premier exemple de réalisation, représenté sur la figure 3B, la couche principale 11 est une couche texturée, de préférence en aluminium. Elle est recouverte par une couche isolante par exemple bi-couches oxyde 52 et d'alumine 51, ayant des ouvertures traversantes débouchant sur la couche principale 11, une première ouverture traversante correspondant à la première zone Z1 et une deuxième ouverture traversante correspondant à la deuxième zone Z2, une partie de la couche d'oxyde 52 disposée entre la première zone Z1 et la deuxième zone Z2 correspondant à la troisième zone Z3.

Avantageusement, une quatrième zone Z4 (zone de séparation) est formée par gravure de la couche 11 débouchante sur la couche isolante 12 et conditionnée par une couche isolante conforme 51.

Avantageusement, avant le dépôt de la couche isolante conforme 51 (couche d'alumine ALD par exemple), le procédé peut également comporter une étape au cours de laquelle on forme une tranchée 80 dans le substrat 10 jusqu'à la couche diélectrique 12 recouvrant le support 13 (figure 3B). La tranchée 80 forme une quatrième zone dans le substrat 10. La quatrième zone Z4 correspondant à une zone de séparation des dispositifs. Cette tranchée 80 peut servir, par exemple, à former des chemins de découpe ou pour dissocier l'électrode inférieure 11.

Avantageusement, lors de l'étape ii), on forme dans cette quatrième zone Z4 des nanopiliers. Les nanopiliers présentent une quatrième densité. La quatrième densité est supérieure à la première densité de la zone capacitive Z1 et à la deuxième capacité de la zone de reprise de contact Z2.

Selon un deuxième exemple de réalisation, le substrat 10 fourni à l'étape i) comprend une couche principale 11 métallique, de préférence en aluminium, recouverte par un premier catalyseur au niveau de la première zone et de la deuxième zone et par un deuxième catalyseur au niveau de la troisième zone. Cette structure peut être obtenue en déposant localement le premier catalyseur et le deuxième catalyseur.

Alternativement, cette structure peut être obtenue en déposant le premier catalyseur puis le deuxième catalyseur, par exemple sous forme de couches minces, des ouvertures dans la couche du deuxième catalyseur laissant accessibles la couche du premier catalyseur, une première ouverture correspondant à la première zone Z1 et une deuxième ouverture correspondant à la deuxième zone Z2, une partie de la couche du deuxième catalyseur disposée entre la première zone Z1 et la deuxième zone Z2 correspondant à la troisième zone Z3.

Le premier catalyseur et/ou le deuxième catalyseur peut être sous la forme d'une couche, par exemple en fer, ou d'un empilement de couches, par exemple un empilement Fe/Ti/AI/Fe.

Une couche d'oxyde peut être disposée entre la couche principale 11 et le premier catalyseur et/ou le deuxième catalyseur.

Il est possible de combiner les modes de réalisation précédemment décrits, et notamment de réaliser localement des anodisations à différents potentiels et de déposer différents catalyseurs.

Lors de l'étape ii), on fait croître une couche de nanopiliers 20. Il peut s'agir de nanotubes de carbone ou de nanofils métalliques (figure 2B ou figure 3C).

La formation des nanofils métalliques ou des nanotubes de carbone peut être réalisée par une étape de croissance mettant en oeuvre des techniques standards. En particulier, les faisceaux de nanotubes de carbone peuvent être formés par DC-PECVD ou DCVD à une température de l'ordre de 400 °C avec différents précurseurs et catalyseurs. Avantageusement, les faisceaux de nanotubes de carbone sont formés par CVD thermique ou assistée par filaments chauds à des températures, par exemple, de l'ordre de 550°C.

Les nanotubes ou les nanofils peuvent présenter une longueur moyenne comprise entre 2 µm et 40 µm, avantageusement comprise entre 2 µm et 12 µm.

Les nanofils sont, par exemple des nanofils de tungstène, cuivre ou nickel.

Les nanofils forment un réseau de nanofils.

Les nanotubes forment un réseau de nanotubes.

Les nanofils ou les nanotubes, et plus particulièrement les nanotubes de carbone, qui présentent un rapport surface/volume important, sont des candidats de choix pour la réalisation de ces structures à facteur de forme élevé.

A l'issue de l'étape ii), au niveau de la première zone Z1 et/ou au niveau de la deuxième zone Z2, l'espacement entre les nanopiliers est compris entre 60 nm et 140 nm.

Avantageusement, au niveau de la troisième zone Z3, l'espacement entre les nanopiliers est compris entre 10 nm et 20 nm.

Lors des étapes iii) et iv), une couche isolante 32 et une couche conductrice 33 sont successivement déposées pour former un empilement capacitif 30 au moins au niveau de la première zone Z1, et éventuellement au niveau de la deuxième zone Z2. L'empilement capacitif continu 30 comprend une couche conductrice supérieure 33 et une couche isolante 32 isolant la couche conductrice supérieure 33 des nanopiliers.

Lors des étapes iii) et iv), une couche isolante 32 et une couche conductrice 33 sont successivement déposées pour former un empilement capacitif 30 au moins au niveau de la première zone Z1, et éventuellement au niveau de la deuxième zone Z2. L'empilement capacitif continu 30 comprend une couche conductrice supérieure 33 et une couche isolante 32 isolant la couche conductrice supérieure 33 des nanopiliers.

Le procédé a été décrit pour un empilement capacitif de type isolant/métal, mais il pourrait également être réalisé pour un empilement capacitif de type métal/isolant/métal (MIM). Selon cette variante de réalisation, le procédé comprend une étape additionnelle, entre l'étape ii) et l'étape iii), au cours de laquelle on dépose une couche conductrice additionnelle 31, l'empilement capacitif de la première zone Z1 comprenant successivement la couche conductrice additionnelle 31, la couche isolante 32 et la couche conductrice 33.

Même si la fabrication d'un empilement capacitif MIM plutôt que d'un empilement capacitif IM semble complexifier l'empilement, cette variante de réalisation présente plusieurs avantages :
- on s'affranchit de la résistance de contact des NTC sur l'aluminium, résistance qui impacte directement les caractéristiques de la capacité en particulier la résistance série (ESR),
- la première couche conductrice 31 devrait aussi pénétrer dans la tresse de NTC et diminuer encore l'ESR,
- à tresse de NTC équivalente, le diamètre de la capacité et la surface développée vont augmenter et donc la densité (µF/mm²) sera plus importante.

De très bonnes performances électriques peuvent ainsi être atteintes avec une MIM.

Le recouvrement simultané des nanopiliers de la zone de reprise de contact Z3 et de la zone capacitive Z1 permet de limiter le nombre d'étapes du procédé.

Le dépôt de la MIM ou IM peut être réalisé par dépôts successifs par une technique de dépôt en couches atomique (ALD). Cette technique de dépôt, particulièrement conforme, permet de déposer l'empilement sur et entre les nanopiliers jusqu'à contacter le substrat, accessible entre les nanopiliers.

La première couche conductrice 31 vient en contact avec le substrat 10 situé tout au fond de la couche de nanopiliers 20. Cette première couche conductrice 31 peut être réalisée à l'aide par exemple d'une technique de dépôt de type ALD. Les matériaux utilisés peuvent être, par exemple, du TiN, du TaN, du NiB, du Ru ou tout autre matériau conducteur.

La couche isolante 32 de l'empilement capacitif 30, permet de créer la capacité entre la couche conductrice supérieure 33 et la couche conductrice inférieure 31. Le matériau utilisé pour réaliser cette couche diélectrique doit avoir une permittivité électrique k la plus élevée possible afin de maximiser la valeur de capacité réalisée. Plusieurs types de matériaux dit matériaux «High-k» préférentiellement avec une permittivité électrique (k>6) peuvent être utilisés, comme par exemple, le nitrure de silicium (Si₃N₄), alumine (oxyde d'aluminium), l'oxyde de hafnium (HfO₂), ou tout autre matériau ayant une permittivité électrique k supérieure ou égale aux matériaux cités précédemment. De plus, les matériaux utilisés doivent être compatibles avec les procédés technologiques utilisés pour la fabrication de la structure à capacité de type MIM.

L'épaisseur de la couche isolante 32 est comprise par exemple entre 5 nm et 80 nm (1 nm = 10⁻⁹ m), préférentiellement elle peut être d'une épaisseur de l'ordre de 10 nm.

Les procédés de dépôt permettant d'obtenir la couche isolante 32 peuvent utiliser différentes techniques connues de l'homme de l'art. À titre d'exemple, le dépôt par couche atomique (en Anglais «Atomic Layer Depostion » ou ALD), ou le dépôt chimique en phase vapeur à basse pression (en Anglais «Low Pressure Chemical Vapor Deposit » ou LPCVD) peuvent être préférentiellement utilisées.

La seconde couche conductrice 33 de l'empilement capacitif 30 est ensuite déposée permettant ainsi de créer la capacité de type MIM. Les caractéristiques de cette seconde couche conductrice ainsi que les méthodes de dépôt peuvent être identiques à celles utilisées pour la réalisation de la première couche conductrice.

La couche conductrice inférieure 31 peut être en nitrure de titane.

La couche conductrice supérieure 33 peut être en nitrure de titane.

La couche isolante 32 peut être en alumine.

De préférence, l'empilement capacitif 30 est un bicouche Al₂O₃/TiN ou un tricouche TiN/Al₂O₃/TiN.

Lors des étapes iii) et iv), un masque 40 permet, avantageusement, de protéger la zone neutre Z3 lors du dépôt de l'empilement capacitif 30. Il peut être fabriqué selon les sous-étapes suivantes :
- une sous-étape de dépôt d'une première couche diélectrique 41, par exemple une couche d'oxyde de silicium,
- une sous-étape de dépôt d'une deuxième couche diélectrique 42, par exemple une couche de nitrure de silicium, de manière à former un empilement diélectrique,
- une sous-étape de photolithographie/gravure destinée à conserver l'empilement exclusivement au niveau de la zone neutre Z3.

Les première 41 et deuxième 42 couches peuvent par exemple présenter une épaisseur comprise entre 10 nm et 1000 nm.

La première couche diélectrique 41 peut comprendre du TEOS et présenter une épaisseur comprise entre 100 et 1000 nm, par exemple égale à 500 nm.

La deuxième couche diélectrique 42, formée en recouvrement de la première couche diélectrique 41, peut présenter une épaisseur comprise entre 100 nm et 500 nm.

Lors des étapes de photolithographie, de gravure et de retrait de résine photosensible (« stripping » selon la terminologie Anglo-Saxonne), on définit un premier motif dans la deuxième couche diélectrique 42 de sorte que cette dernière forme un masque dur. Le deuxième motif est obtenu par gravure sèche à travers ce masque dur protégeant la structure (NTC, fils...) de tout procédé humide. Il est entendu que le premier motif et le deuxième motif forment des ouvertures traversantes dans la couche diélectrique 40. Ce premier motif et ce deuxième motif permettent en particulier de délimiter la zone capacitive et la zone de reprise de contact respectivement.

Lors de l'étape v), l'électrode supérieure 60 est formée sur la première zone Z1 (figure 2D).

L'électrode supérieure 60 formée lors de l'étape e) est obtenue en déposant une couche de métal. L'électrode supérieure 60 a une épaisseur, par exemple de l'ordre de 1 µm à 5 µm. Les matériaux utilisés pour l'électrode supérieure peuvent être par exemple de l'aluminium (AI), du cuivre (Cu), de l'argent (Ag) combinés ou non avec des métaux barrières comme par exemple le nitrure de titane (TiN), ou le nitrure de tantale (TaN). Par exemple, il peut s'agir d'un alliage AlCu.

L'électrode supérieure 60 est agencée de manière à contacter électriquement la couche conductrice supérieure 33 de l'empilement capacitif 30. L'électrode supérieure 60 peut être recouverte d'une ou plusieurs couches de matériau isolant. Une reprise de contact en la forme d'un plot métallique (« UBM » ou « Upper Bump Metallurgy » selon la terminologie anglo-saxonne) peut être formée au travers de la couche ou des couches en matériaux isolants. Il peut s'agir d'une couche d'oxyde de silicium, une couche de nitrure de silicium ou d'une bicouche comprenant les deux couches précitées.

L'électrode supérieure 60 peut présenter un léger recouvrement avec les couches diélectriques de la zone neutre Z3.

Ensuite, lors de l'étape vi), l'électrode inférieure 70 est formée sur la zone de reprise de contact Z2. L'étape vi) peut être réalisée selon un protocole similaire à celui employé pour la formation de l'électrode supérieure 60 (étape v). Le plot de contact pour l'électrode inférieure 70 peut être en un matériau identique ou différent de celui de l'électrode supérieure 60. Le plot de l'électrode inférieure 70 est par exemple en AlCu.

Le plot de l'électrode inférieure 70 peut être recouverte par une couche de matériau isolant 71. Une reprise de contact en la forme d'un plot métallique (« UBM ») peut être formée à travers cette couche.

Entre l'étape v) et l'étape vi), on peut, avantageusement, réaliser les étapes suivantes :
- graver la couche supérieure du dispositif capacitif (10 nm de TiN) à travers le masque dur de la couche conductrice 60,
- déposer une couche de protection 61 sur l'électrode supérieure 60, pour protéger l'électrode supérieure 60 en vue de l'étape destinée à exposer à l'environnement extérieur la zone de contact inférieur Z2 ; par exemple, on pourra former une couche diélectrique 61 en recouvrement de l'électrode supérieure 60,
- graver l'empilement capacitif 30 au niveau de la deuxième zone Z2 de manière à rendre accessibles les nanopiliers au niveau de la deuxième zone Z2, et ainsi permettre d'exposer à l'environnement extérieur la zone de contact inférieur ZCI.

Un ou plusieurs plots de contact peuvent être formés au niveau de l'électrode supérieure et/ou de l'électrode inférieure.

Enfin, le procédé de fabrication du dispositif capacitif peut se terminer par la formation d'une couche de passivation et de l'ouverture de cette dernière en deux points de contact de manière à accéder électriquement à l'électrode supérieure et à l'électrode inférieure.

Les points de contact sont notamment des plots métalliques (« UBM »).

A l'issue du procédé de fabrication, l'empilement final est prêt à être découper (figure 3F).

Le procédé peut également comporter une étape ultérieure au cours de laquelle on sépare des dispositifs capacitifs formés sur un même substrat 10 au niveau des zones de découpe Z4.

Le dispositif capacitif ainsi obtenu est remarquable en ce qu'il comporte une couche de nanopiliers 20 formée pleine plaque recouverte.

L'agencement de l'empilement capacitif 30 permet de définir une zone capacitive Z1 (première zone) et une zone de contact inférieur Z2 (deuxième zone) au sein du dispositif capacitif. Notamment, la zone capacitive est une zone au niveau de laquelle l'empilement capacitif encapsule les nanopiliers, tandis que la zone de contact inférieur est une zone au niveau de laquelle d'une part l'empilement capacitif laisse découvert une extrémité des nanopiliers tout en recouvrant latéralement les nanopiliers.

Alternativement, la reprise de contact peut être formée en remplissant partiellement ou totalement l'espace inter-piliers, au niveau de la deuxième zone Z2, avec un élément électriquement conducteur, par exemple du cuivre, du nickel, du tungstène. Cet élément électriquement conducteur peut être déposé par dépôt électrochimique (ECD) ou par dépôt de couches atomiques (ALD).

Une zone neutre Z3 (troisième zone) s'interpose entre la zone capacitive Z1 et la zone de contact inférieur Z2. En regard de la zone neutre Z3, il n'y a pas d'empilement capacitif. Autrement dit, au niveau de la zone neutre, les nanopiliers ne sont pas recouverts par la totalité des couches de l'empilement capacitif.

La zone neutre Z3 peut être recouverte d'au moins une couche d'encapsulation faite de matériau isolant. La couche d'encapsulation peut notamment comprendre une couche d'oxyde de silicium ou une couche de nitrure de silicium. Il est également possible d'avoir une bicouche comprenant une couche de nitrure de silicium recouvrant la couche d'oxyde de silicium.

Exemples illustratifs et non limitatifs d'un mode de réalisation :
Différentes couches de nanopiliers (nanotubes de carbone) ont été observées au microscope électronique à balayage (MEB). Elles ont été obtenues sur des substrats comprenant une couche principale 11 en aluminium/alumine ayant différentes texturations et recouvertes d'une couche catalytique ou d'un empilement catalytique de différentes natures :
- couche principale 11 en aluminium anodisée à 60V recouverte d'une couche catalytique en fer (figure 4A),
- couche principale en aluminium anodisée à 90V recouverte d'une couche catalytique en fer (figure 4B),
- couche principale en Al₂O₃ plane recouverte d'une couche catalytique en fer (figure 4C),
- couche principale en Al₂O₃ plane recouverte d'un empilement catalytique Fe/Ti/AI/Fe (figure 4D).

Les densités de NTC obtenues sont différentes sur ces différents substrats.

Dans les exemples 1 et 2 suivants, nous allons décrire plus en détail des procédés de fabrication d'un dispositif capacitif. Les natures et épaisseurs des couches conductrices ou isolantes sont données à titre indicatif.

### Exemple 1

1) Dépôt d'une couche diélectrique 12 de SiO₂ (SiH₄) pleine plaque 500 nm sur un support 13 de Silicium,
2) Dépôt d'une couche principale 11 d'Aluminium de 3 µm pleine plaque,
3) Anodisation d'environ 1 µm de la couche principale 11 en aluminium (on pourra jouer sur la tension d'anodisation, la température du bain et l'électrolyte pour définir « l'arrangement » de l'alumine formée, en particulier l'espacement (« pitch »),
4) Gravure de l'alumine formée pour révéler une surface d'AI préformée organisée (figure 3A),
5) Dépôt de 200 nm d'une couche 52 de SiO₂ (TEOS par exemple),
6) Polissage mécano-chimique de la couche 52 de SiO₂ (« smoothing »),
7) Structuration de la couche 52 de SiO₂ par photolithographie puis gravure du SiO₂ et Al avec arrêt sur la couche de SiO₂ 12 déposée à l'étape 1) pour former la zone Z4,
8) Dépôt d'une couche 51 de Al₂O₃ par ALD,
9) Ouverture des couches 51 et 52 en Al₂O₃ et SiO₂, lithographie et gravure sèche arrêt sur la couche 11 en aluminium (figure 3B),
10) Dépôt du catalyseur et croissance de la couche 20 de nanotubes de carbone ou NTC (figure 3C) :
   - Croissance en tresse sur la première zone Z1 (zone capacitive) et sur la deuxième zone Z2 (zone de reprise de contact de l'électrode inférieure) avec un espace libre important (généralement on vise un espace de 60 nm avec un pitch de 140 nm).
   - Croissance sur la troisième zone Z3 (zone d'isolation de l'électrode supérieure) et sur la quatrième zone Z4 (zone de séparation des électrodes inférieures et chemin de découpe) sans formation spécifiquement de tresse et avec un espace libre faible (par exemple de l'ordre de 10 à 20 nm),
11) Dépôt d'une couche isolante 32 en Al₂O₃ par ALD (figure 3C),
12) Dépôt d'une couche de 200nm de SiO₂, puis
13) Dépôt d'une couche de SiN de 100 nm, de manière à former un masque 40,
14) Structuration de SiN, lithographie gravure SiN avec arrêt sur SiO₂, retrait de résine photosensible (« stripping ») et définition de la zone capacitive Z1,
15) Ouverture du SiO₂ sur Al₂O₃ à travers le masque dur SiN - gravure sèche (figure 3D),
16) Dépôt par ALD d'une couche conductrice 33 de TiN 10 nm (figure 3E), pour former un empilement capacitif 30 de type IM,
17) Dépôt AI ou AlCu ou AISi 1 µm, pour former une électrode supérieure 60,
18) Structuration du plot « électrode supérieure » d'Alu, lithographie et gravure Alu arrêt sur TiN,
19) Gravure sèche du TiN arrêt sur SiN à travers le masque dur d'Alu
20) Passivation avec une couche 61 de SiN 100 nm,
21) Structuration du SiN, lithographie gravure SiN arrêt sur SiO₂, retrait de résine photosensible (« stripping »), et définition de la zone de reprise de contact Z2,
22) Ouverture du SiO₂ sur Al₂O₃ à travers le masque dur SiN (gravure sèche),
23) Gravure Al₂O₃ arrêt sur NTC (gravure sèche avec surgravure),
24) Dépôt AI ou AlCu ou AISi 1 µm, pour former une électrode inférieure 70,
25) Structuration du plot « électrode inférieure » d'AICu, lithographie et gravure Alu arrêt sur SiN,
26) Ouverture de la passivation SiN sur le plot « électrode supérieure », lithographie et gravure SiN arrêt sur AlCu (figure 3F),
27) Discrétisation dispositifs (suivant les chemins de découpe dans les zone sans la couche d'Alu, zone Z4).

### Exemple 2 :

On réalise les étapes 1) à 10) de l'exemple 1) puis les étapes suivantes :
11) Dépôt pleine plaque en ALD de l'empilement capacitif 30 de type « MIM », formée d'une couche conductrice inférieure 31 (par exemple 10 nm TiN), une couche isolante 32 (20 nm d'Al₂O₃ par exemple) et une couche conductrice supérieure 33 (10 nm de TiN par exemple),
12) Dépôt AlCu, pour former une électrode supérieure 60,
13) Structuration du plot « électrode supérieure » d'AICu (« patterning »), gravure AlCu et TiN (arrêt sur Al₂O₃),
14) Dépôt d'une couche 61 de SiN, puis ouverture de SiN,
15) Dépôt AlCu, pour former une électrode inférieure 70,
16) Structuration du plot « électrode inférieure » d'Alu, lithographie et gravure Alu arrêt sur SiN,
17) Ouverture de la passivation SiN sur le plot « électrode supérieure », lithographie et gravure SiN arrêt sur AlCu,
18) Discrétisation dispositifs (suivant les chemins de découpe dans les zone sans la couche d'Alu, zone Z4).

### Variantes de réalisation des exemples 1 et 2 :

Dans l'exemple 1, il est également possible de réaliser un dépôt préalable d'une couche conductrice 31 de TiN par ALD sur les tresses de NTC, avant l'étape 8), pour former un empilement capacitif de type MIM.

Dans les exemples 1 et 2, il est possible d'utiliser deux empilements catalytiques différents dans les zones capacitives et d'isolation de façon à obtenir des densités de NTC différentes dans les deux zones.

Dans les exemples 1 et 2, il est possible de ne pas déposer de SiO₂ (étape 5) et/ou de ne pas réaliser l'étape de planarisation sur la zone isolation (étape 6).

Deux empilements catalytiques différents peuvent alors être utilisés dans les zones capacitives et d'isolation de façon à obtenir des densités de NTC différentes dans les deux zones.

Selon une autre variante de réalisation deux procédés d'anodisation différents peuvent être utilisés dans les zones capacitives et d'isolation (par exemple une anodisation à 90V dans la zone capacitive et une anodisation à 60V dans la zone d'isolation) pour obtenir différentes structurations de la couche d'Aluminium et ainsi différentes densités de NTC après croissance.

## Revendications

1. Procédé de fabrication d'un dispositif capacitif comprenant les étapes suivantes :
i) fournir un substrat (10) comprenant :
- une première zone (Z1) en un premier matériau et/ou ayant une première texturation,
- une deuxième zone (Z2) en un deuxième matériau et/ou ayant une deuxième texturation,
- une troisième zone (Z3) en un troisième matériau et/ou ayant une troisième texturation, le premier matériau étant différent du troisième matériau et/ou la première texturation étant différente de la troisième texturation,
le premier matériau pouvant être identique ou différent du deuxième matériau et/ou la première texturation pouvant être identique ou différente de la deuxième texturation,
ii) faire croître des nanopiliers, de préférence des nanotubes de carbone ou des nanofils métalliques, sur le substrat (10), moyennant quoi on obtient une couche de nanopiliers (20) présentant localement différentes densités, les nanopiliers au niveau de la première zone (Z1) ayant une première densité, les nanopiliers au niveau de la deuxième zone (Z2) ayant une deuxième densité, les nanopiliers au niveau de la troisième zone (Z3) ayant une troisième densité, la première et la deuxième densités étant inférieures à la troisième densité, la première densité pouvant être identique ou différente de la deuxième densité,
iii) déposer une couche isolante (32) sur la couche de nanopiliers (20), la couche isolante (32) recouvrant de manière conforme et continue les nanopiliers au moins au niveau de la première zone (Z1),
iv) déposer une couche conductrice (33), sur la couche de nanopiliers (20), la couche conductrice (33) recouvrant de manière conforme et continue la couche isolante (32) au moins au niveau de la première zone (Z1), moyennant quoi on forme un empilement capacitif (30) au niveau de la première zone (Z1), l'empilement capacitif (30) comprenant la couche isolante (32) et la couche conductrice (33).

2. Procédé selon la revendication 1, **caractérisé en ce que** les étapes iii) et iv) sont réalisées en déposant la couche isolante (32) et la couche conductrice (33) pleine plaque, la couche isolante (32) et la couche conductrice (33) recouvrant de manière conforme la couche de nanopiliers (20) au niveau de la première zone (Z1) et au niveau de la deuxième zone (Z2), de manière à former une reprise de contact au niveau de la deuxième zone (Z2), la couche isolante (32) bouchant l'espace entre les nanopiliers au niveau de la troisième zone (Z3), moyennant quoi on forme une zone d'isolation électrique.

3. Procédé selon la revendication 1, **caractérisé en ce que**, entre les étapes iii) et iv), le procédé comporte une étape au cours de laquelle on forme un masque (40) sur la couche de de nanopiliers au niveau de la troisième zone (Z3).

4. Procédé selon la revendication 3, **caractérisé en ce que** le masque (40) recouvre la couche de nanopiliers (20) au niveau de la deuxième zone (Z2) et au niveau de la troisième zone (Z3).

5. Procédé selon l'une quelconque des revendications précédentes, **caractérisé en ce que**, au niveau de la première zone (Z1) et/ou au niveau de la deuxième zone (Z2), l'espacement entre les nanopiliers est compris entre 60 nm et 140 nm.

6. Procédé selon l'une quelconque des revendications précédentes, **caractérisé en ce que**, au niveau de la troisième zone (Z3), l'espacement entre les nanopiliers est compris entre 10 nm et 20 nm.

7. Procédé selon l'une quelconque des revendications précédentes, **caractérisé en ce que** le procédé comporte une étape additionnelle, entre l'étape ii) et l'étape iii), au cours de laquelle on dépose une couche conductrice additionnelle (31), l'empilement capacitif de la première zone (Z1) comprenant la couche conductrice additionnelle (31), la couche isolante (32) et la couche conductrice (33).

8. Procédé selon l'une quelconque des revendications 1 à 7, **caractérisé en ce que** le substrat (10) fourni à l'étape i) comprend une couche principale d'aluminium (11) recouverte par une couche d'oxyde (51), par exemple en oxyde d'aluminium, ayant des ouvertures traversantes débouchant sur la couche principale d'aluminium (11), une première ouverture traversante correspondant à la première zone (Z1) et une deuxième ouverture traversante correspondant à la deuxième zone (Z2), une partie de la couche d'oxyde disposée entre la première zone (Z1) et la deuxième zone (Z2) correspondant à la troisième zone (Z3).

9. Procédé selon l'une quelconque des revendications 1 à 7, **caractérisé en ce que** le substrat (10) fourni à l'étape i) comprend une couche principale en aluminium (11) recouverte par un premier catalyseur et par un deuxième catalyseur, la première zone (Z1) et la deuxième zone (Z2) étant formées au niveau du premier catalyseur et la troisième zone (Z3) étant formée au niveau du deuxième catalyseur, une couche d'oxyde pouvant être disposée entre la couche principale (11) en aluminium et la deuxième couche catalytique.

10. Procédé selon l'une quelconque des revendications 1 à 7, **caractérisé en ce que** le substrat fourni à l'étape i) est obtenu selon les étapes suivantes :
a) fournir un substrat (10) comprenant une couche principale en aluminium (11),
b) structurer localement une première partie de la couche principale (11) d'aluminium par un premier procédé d'anodisation, de manière à définir une première zone (Z1),
c) structurer localement une deuxième partie de la couche principale (11) d'aluminium par un deuxième procédé d'anodisation, de manière à définir une deuxième zone (Z2),
d) structurer localement une troisième partie de la couche principale (11) d'aluminium par un troisième procédé d'anodisation, de manière à définir une troisième zone (Z3),
e) réaliser une étape de gravure,
moyennant quoi on obtient une couche principale d'aluminium (11) structurée comprenant une première structuration au niveau de la première zone, une deuxième structuration au niveau de la deuxième zone et une troisième structuration au niveau de la troisième zone,
la première structuration étant différente de la troisième structuration,
la première structuration étant identique ou différente de la deuxième structuration.

11. Procédé selon l'une quelconque des revendications précédentes, **caractérisé en ce que** le substrat (10) comprend un support (13) comprenant une couche diélectrique (12), de préférence en oxyde de silicium, une tranchée (80) étant formée à travers le substrat (10) jusqu'à la couche diélectrique (12) recouvrant le support (13), la tranchée (80) formant une quatrième zone (Z4),
Et **en ce que** lors de l'étape ii) on fait croître des nanopiliers au niveau de la quatrième zone (Z4), les nanopiliers ayant une quatrième densité, la quatrième densité étant supérieure à la première densité et à la deuxième densité.

12. Dispositif capacitif obtenu selon l'une quelconque des revendications 1 à 11 comprenant :
- un substrat (10) comprenant :
- une première zone (Z1) en un premier matériau et/ou ayant une première texturation,
- une deuxième zone (Z2) en un deuxième matériau et/ou ayant une deuxième texturation,
- une troisième zone (Z3) en un troisième matériau et/ou ayant une troisième texturation, le premier matériau étant différent du troisième matériau et/ou la première texturation étant différente de la troisième texturation,
le premier matériau pouvant être identique ou différent du deuxième matériau et/ou la première texturation pouvant être identique ou différente de la deuxième texturation,
- une couche de nanopiliers (20), de préférence des nanotubes de carbone ou des nanofils métalliques, recouvrant le substrat (10) et présentant localement différentes densités, les nanopiliers au niveau de la première zone (Z1) ayant une première densité, les nanopiliers au niveau de la deuxième zone (Z2) ayant une deuxième densité, les nanopiliers au niveau de la troisième zone (Z3) ayant une troisième densité, la première et la deuxième densités étant inférieures à la troisième densité, la première densité pouvant être identique ou différente de la deuxième densité,
- un empilement capacitif (30) recouvrant de manière conforme et continue les nanopiliers, au niveau de la première zone (Z1), de manière à former une zone capacitive, l'empilement capacitif comprenant la couche isolante (32) et la couche conductrice (33), et éventuellement une couche conductrice additionnelle (31) entre les nanopiliers et la couche isolante (32).

13. Dispositif capacitif selon la revendication 12, **caractérisé en ce que** le dispositif comprend une reprise de contact au niveau de la deuxième zone (Z2), la reprise de contact étant formée d'un empilement capacitif additionnel recouvrant de manière conforme et continue les nanopiliers au niveau de la deuxième zone (Z2), l'empilement capacitif additionnel étant avantageusement identique à l'empilement capacitif de la première zone (Z1).

14. Dispositif capacitif selon l'une des revendications 12 et 13, **caractérisé en ce que** la couche isolante (32) remplit complètement l'espace entre les nanopiliers au niveau de la troisième zone (Z3), moyennant quoi on forme une zone d'isolation entre la zone capacitive et la zone de reprise de contact.

15. Dispositif selon la revendication précédente, **caractérisé en ce que** le substrat (10) comprend un support (13) recouvert par une couche diélectrique (12), de préférence une couche d'oxyde de silicium, une tranchée (80) étant formée à travers le substrat (10) jusqu'à la couche diélectrique (12) recouvrant le support (13), la tranchée formant une quatrième zone (Z4)
des nanopiliers ayant une quatrième densité remplissant la tranchée (80), la quatrième densité étant supérieure à la première densité et à la deuxième densité.

## Patentansprüche

1. Verfahren zur Herstellung einer kapazitiven Vorrichtung, die folgenden Schritte umfassend:
i) Bereitstellen eines Substrats (10), umfassend:
- eine erste Zone (Z1) aus einem ersten Material und/oder mit einer ersten Texturierung,
- eine zweite Zone (Z2) aus einem zweiten Material und/oder mit einer zweiten Texturierung,
- eine dritte Zone (Z3) aus einem dritten Material und/oder mit einer dritten Texturierung, wobei sich das erste Material vom dritten Material unterscheidet und/oder sich die erste Texturierung von der dritten Texturierung unterscheidet,
wobei das erste Material mit dem zweiten Material identisch oder verschieden sein kann, und/oder die erste Texturierung mit der zweiten Texturierung identisch oder verschieden sein kann,
ii) Wachsen lassen von Nanosäulen, vorzugsweise Kohlenstoffnanoröhren oder metallische Nanodrähte, auf dem Substrat (10), wodurch eine Schicht aus Nanosäulen (20) erhalten wird, die lokal unterschiedliche Dichten aufweisen, wobei die Nanosäulen im Bereich der ersten Zone (Z1) eine erste Dichte haben, die Nanosäulen im Bereich der zweiten Zone (Z2) eine zweite Dichte haben und die Nanosäulen im Bereich der dritten Zone (Z3) eine dritte Dichte haben, wobei die erste und die zweite Dichte kleiner als die dritte Dichte sind, wobei die erste Dichte identisch oder verschieden von der zweiten Dichte sein kann,
iii) Abscheiden einer Isolierschicht (32) auf der Nanosäulenschicht (20), wobei die Isolierschicht (32) die Nanosäulen mindestens im Bereich der ersten Zone (Z1) gleichmäßig und kontinuierlich bedeckt,
iv) Abscheiden einer leitenden Schicht (33) auf der Nanosäulenschicht (20), wobei die leitende Schicht (33) die Isolierschicht (32) mindestens im Bereich der ersten Zone (Z1) gleichmäßig und kontinuierlich bedeckt, wodurch im Bereich der ersten Zone (Z1) ein kapazitiver Stapel (30) gebildet wird, wobei der kapazitive Stapel (30) die Isolierschicht (32) und die leitende Schicht (33) umfasst.

2. Verfahren nach Anspruch 1, **dadurch gekennzeichnet, dass** die Schritte iii) und iv) durchgeführt werden, indem die Isolierschicht (32) und die leitende Schicht (33) als Vollplatten abgeschieden werden, wobei die Isolierschicht (32) und die leitende Schicht (33) die Nanosäulenschicht (20) im Bereich der ersten Zone (Z1) und im Bereich der zweiten Zone (Z2) gleichmäßig bedecken, so dass im Bereich der zweiten Zone (Z2) eine Wiederaufnahme des Kontakts gebildet wird, wobei die Isolierschicht (32) den Raum zwischen den Nanosäulen im Bereich der dritten Zone (Z3) verschließt, wodurch eine elektrische Isolationszone gebildet wird.

3. Verfahren nach Anspruch 1, **dadurch gekennzeichnet, dass** das Verfahren zwischen den Schritten iii) und iv) einen Schritt beinhaltet, wobei eine Maske (40) auf der Nanosäulenschicht im Bereich der dritten Zone (Z3) gebildet wird.

4. Verfahren nach Anspruch 3, **dadurch gekennzeichnet, dass** die Maske (40) die Nanosäulenschicht (20) im Bereich der zweiten Zone (Z2) und im Bereich der dritten Zone (Z3) bedeckt.

5. Verfahren nach einem der vorhergehenden Ansprüche, **dadurch gekennzeichnet, dass** im Bereich der ersten Zone (Z1) und/oder im Bereich der zweiten Zone (Z2) der Abstand zwischen den Nanosäulen zwischen 60 nm und 140 nm liegt.

6. Verfahren nach einem der vorhergehenden Ansprüche, **dadurch gekennzeichnet, dass** im Bereich der dritten Zone (Z3) der Abstand zwischen den Nanosäulen zwischen 10 nm und 20 nm liegt.

7. Verfahren nach einem der vorhergehenden Ansprüche, **dadurch gekennzeichnet, dass** das Verfahren einen zusätzlichen Schritt zwischen Schritt ii) und Schritt iii) beinhaltet, wobei eine zusätzliche leitende Schicht (31) abgeschieden wird, wobei der kapazitive Stapel der ersten Zone (Z1) die zusätzliche leitende Schicht (31), die Isolierschicht (32) und die leitende Schicht (33) umfasst.

8. Verfahren nach einem der Ansprüche 1 bis 7, **dadurch gekennzeichnet, dass** das in Schritt i) bereitgestellte Substrat (10) eine Hauptschicht aus Aluminium (11) umfasst, die von einer Oxidschicht (51) bedeckt ist, beispielsweise Aluminiumoxid, und durchgehende Öffnungen hat, die in der Hauptschicht aus Aluminium (11) ausmünden, wobei eine erste durchgehende Öffnung der ersten Zone (Z1) entspricht und eine zweite durchgehende Öffnung der zweiten Zone (Z2) entspricht, wobei ein Teil der Oxidschicht, der zwischen der ersten Zone (Z1) und der zweiten Zone (Z2) angeordnet ist, der dritten Zone (Z3) entspricht.

9. Verfahren nach einem der Ansprüche 1 bis 7, **dadurch gekennzeichnet, dass** das in Schritt i) bereitgestellte Substrat (10) eine Hauptschicht aus Aluminium (11) umfasst, die von einem ersten Katalysator und einem zweiten Katalysator bedeckt ist, wobei die erste Zone (Z1) und die zweite Zone (Z2) im Bereich des ersten Katalysators gebildet sind und die dritte Zone (Z3) im Bereich des zweiten Katalysators gebildet ist, wobei eine Oxidschicht zwischen der Hauptschicht aus Aluminium (11) und der zweiten Katalysatorschicht angeordnet werden kann.

10. Verfahren nach einem der Ansprüche 1 bis 7, **dadurch gekennzeichnet, dass** das in Schritt i) bereitgestellte Substrat durch die folgenden Schritte erhalten wird:
a) Bereitstellen eines Substrats (10), das eine Hauptschicht aus Aluminium (11) umfasst,
b) lokales Strukturieren eines ersten Teils der Hauptschicht aus Aluminium (11) durch ein erstes Anodisierungsverfahren, um eine erste Zone (Z1) zu definieren,
c) lokales Strukturieren eines zweiten Teils der Hauptschicht aus Aluminium (11) durch ein zweites Anodisierungsverfahren, um eine zweite Zone (Z2) zu definieren,
d) lokales Strukturieren eines dritten Teils der Hauptschicht aus Aluminium (11) durch ein drittes Anodisierungsverfahren, um eine dritte Zone (Z3) zu definieren,
e) Durchführen eines Ätzschrittes,
wodurch eine strukturierte Hauptschicht aus Aluminium (11) erhalten wird, die eine erste Strukturierung im Bereich der ersten Zone, eine zweite Strukturierung im Bereich der zweiten Zone und eine dritte Strukturierung im Bereich der dritten Zone umfasst,
wobei sich die erste Strukturierung von der dritten Strukturierung unterscheidet,
wobei die erste Strukturierung identisch oder verschieden von der zweiten Strukturierung ist.

11. Verfahren nach einem der vorhergehenden Ansprüche, **dadurch gekennzeichnet, dass** das Substrat (10) einen Träger (13) umfasst, der eine dielektrische Schicht (12) umfasst, vorzugsweise aus Siliziumoxid, wobei eine Schneise (80) durch das Substrat (10) bis zur dielektrischen Schicht (12), die den Träger (13) bedeckt, gebildet ist, wobei die Schneise (80) eine vierte Zone (Z4) bildet,
und dass in Schritt ii) Nanosäulen im Bereich der vierten Zone (Z4) zum Wachsen gebracht werden, wobei die Nanosäulen eine vierte Dichte hat, wobei die vierte Dichte größer ist als die erste Dichte und die zweite Dichte.

12. Kapazitive Vorrichtung, die nach einem der Ansprüche 1 bis 11 erhalten wird, umfassend:
- ein Substrat (10), umfassend:
- eine erste Zone (Z1) aus einem ersten Material und/oder mit einer ersten Texturierung,
- eine zweite Zone (Z2) aus einem zweiten Material und/oder mit einer zweiten Texturierung,
- eine dritte Zone (Z3) aus einem dritten Material und/oder mit einer dritten Texturierung, wobei sich das erste Material vom dritten Material unterscheidet und/oder sich die erste Texturierung von der dritten Texturierung unterscheidet,
wobei das erste Material mit dem zweiten Material identisch oder verschieden sein kann und/oder die erste Texturierung mit der zweiten Texturierung identisch oder verschieden sein kann,
- eine Schicht aus Nanosäulen (20), vorzugsweise Kohlenstoffnanoröhren oder metallische Nanodrähte, die das Substrat (10) bedecken und lokal unterschiedliche Dichten aufweisen, wobei die Nanosäulen im Bereich der ersten Zone (Z1) eine erste Dichte haben, die Nanosäulen im Bereich der zweiten Zone (Z2) eine zweite Dichte haben und die Nanosäulen im Bereich der dritten Zone (Z3) eine dritte Dichte haben, wobei die erste und die zweite Dichte kleiner als die dritte Dichte sind, wobei die erste Dichte identisch oder verschieden von der zweiten Dichte sein kann,
- einen kapazitiven Stapel (30), der die Nanosäulen im Bereich der ersten Zone (Z1) gleichmäßig und kontinuierlich bedeckt, so dass eine kapazitive Zone gebildet wird, wobei der kapazitive Stapel die Isolierschicht (32) und die leitende Schicht (33) umfasst, und gegebenenfalls eine zusätzliche leitende Schicht (31) zwischen den Nanosäulen und der Isolierschicht (32).

13. Kapazitive Vorrichtung nach Anspruch 12, **dadurch gekennzeichnet, dass** die Vorrichtung eine Wiederaufnahme des Kontakts im Bereich der zweiten Zone (Z2) umfasst, wobei die Wiederaufnahme des Kontakts durch einen zusätzlichen kapazitiven Stapel gebildet wird, der die Nanosäulen im Bereich der zweiten Zone (Z2) gleichmäßig und kontinuierlich bedeckt, wobei der zusätzliche kapazitive Stapel vorteilhafterweise mit dem kapazitiven Stapel der Zone (Z1) identisch ist.

14. Kapazitive Vorrichtung nach einem der Ansprüche 12 und 13, **dadurch gekennzeichnet, dass** die Isolierschicht (32) den Raum zwischen den Nanosäulen im Bereich der dritten Zone (Z3) vollständig ausfüllt, wodurch eine Isolationszone zwischen der kapazitiven Zone und der Zone der Wiederaufnahme des Kontakts gebildet wird.

15. Vorrichtung nach dem vorhergehenden Anspruch, **dadurch gekennzeichnet, dass** das Substrat (10) einen Träger (13) umfasst, der von einer dielektrischen Schicht (12) bedeckt ist, vorzugsweise einer Siliziumoxidschicht, wobei eine Schneise (80) durch das Substrat (10) bis zur dielektrischen Schicht (12), die den Träger (13) bedeckt, gebildet ist, wobei die Schneise eine vierte Zone (Z4) von Nanosäulen bildet, die eine vierte Dichte haben, die die Schneise (80) ausfüllt, wobei die vierte Dichte größer ist als die erste Dichte und die zweite Dichte.

## Claims

1. Method for manufacturing a capacitive device comprising the following steps:
i) provide a substrate (10) comprising:
- a first area (Z1) made of a first material and/or having a first texture,
- a second area (Z2) made of a second material and/or having a second texture,
- a third area (Z3) made of a third material and/or having a third texture, the first material being different from the third material and/or the first texture being different from the third texture,
the first material may be identical to or different from the second material and/or the first texture may be identical to or different from the second texture,
ii) make nanopillars grow over the substrate (10), with which a nanopillar layer (20) is obtained locally having different densities, the nanopillars at the first area (Z1) having a first density, the nanopillars at the second area (Z2) having a second density, the nanopillars at the third area (Z3) having a third density, the first density and the second density being lower than the third density, the first density may be identical to or different from the second density,
iii) deposit an insulating layer (32) over the nanopillar layer (20), the insulating layer (32) covering the nanopillars in a conformal and continuous manner at least at the first area (Z1),
iv) deposit a conductive layer (33), over the nanopillar layer (20), the conductive layer (33) covering the insulating layer (32) in a conformal and continuous manner at least at the first area (Z1), with which a capacitive stack (30) is formed at the first area (Z1), the capacitive stack (30) comprising the insulating layer (32) and the conductive layer (33).

2. Method according to claim 1, **characterised in that** steps iii) and iv) are carried out by full-plate depositing the insulating layer (32) and the conductive layer (33), the insulating layer (32) and the conductive layer (33) covering the nanopillar layer (20) in a conformal manner at the first area (Z1) and at the second area (Z2), so as to form a contact resumption at the second area (Z2), the insulating layer (32) plugging the space between the nanopillars at the third area (Z3), with which an electrically insulating area is formed.

3. Method according to claim 1, **characterised in that**, between steps iii) and iv), the method includes a step during which a mask (40) is formed over the nanopillar layer at the third area (Z3).

4. Method according to claim 3, **characterised in that** the mask (40) covers the nanopillar layer (20) at the second area (Z2) and at the third area (Z3).

5. Method according to any one of the preceding claims, **characterised in that**, at the first area (Z1) and/or at the second area (Z2), the spacing between the nanopillars is comprised between 60 nm and 140 nm.

6. Method according to any one of the preceding claims, **characterised in that**, at the third area (Z3), the spacing between the nanopillars is comprised between 10 nm and 20 nm.

7. Method according to any one of the preceding claims, **characterised in that** the method includes an additional step, between step ii) and step iii), during which an additional conductive layer (31) is deposited, the capacitive stack of the first area (Z1) comprising the additional conductive layer (31), the insulating layer (32) and the conductive layer (33).

8. Method according to any one of claims 1 to 7, **characterised in that** the substrate (10) provided at step i) comprises a main aluminium layer (11) covered with an oxide layer (51), for example made of aluminium oxide, having through openings leading onto the main aluminium layer (11), a first through opening corresponding to the first area (Z1) and a second through opening corresponding to the second area (Z2), a portion of the oxide layer disposed between the first area (Z1) and the second area (Z2) corresponding to the third area (Z3).

9. Method according to any one of claims 1 to 7, **characterised in that** the substrate (10) provided at step i) comprises a main layer (11) made of aluminium covered with a first catalyst and with a second catalyst, the first area (Z1) and the second area (Z2) being formed at the first catalyst and the third area (Z3) being formed at the second catalyst, an oxide layer may be disposed between the main layer (11) made of aluminium and the second catalytic layer.

10. Method according to any one of claims 1 to 7, **characterised in that** the substrate (10) provided at step i) is obtained according to the following steps:
a) provide a substrate (10) comprising a main aluminium layer (11),
b) locally structure a first portion of the main aluminium layer (11) by a first anodising process, so as to define a first area (Z1),
c) locally structure a second portion of the main aluminium layer (11) by a second anodising process, so as to define a second area (Z2),
d) locally structure a third portion of the main aluminium layer (11) by a third anodising process, so as to define a third area (Z3),
e) carry out an etching step,
with which a structured main aluminium layer (11) is obtained comprising a first structure at the first area, a second structure at the second area and a third structure at the third area,
the first structure being different from the third structure,
the first structure being identical to or different from the second structure.

11. Method according to any one of the preceding claims, **characterised in that** the substrate (10) comprises a support (13) comprising a dielectric layer (12), preferably made of silicon oxide, a trench (80) being formed through the substrate (10) up to the dielectric layer (12) covering the support (13), the trench (80) forming a fourth area (Z4),
and **in that** during step ii) nanopillars are grown at the fourth area (Z4), the nanopillars having a fourth density, the fourth density being higher than the first density and than the second density.

12. Capacitive device obtained according to any one of claims 1 to 11 comprising:
- a substrate (10) comprising:
- a first area (Z1) made of a first material and/or having a first texture,
- a second area (Z2) made of a second material and/or having a second texture,
- a third area (Z3) made of a third material and/or having a third texture, the first material being different from the third material and/or the first texture being different from the third texture,
the first material may be identical to or different from the second material and/or the first texture may be identical to or different from the second texture,
- a layer (20) of nanopillars, covering the substrate (10) and locally having different densities, the nanopillars at the first area (Z1) having a first density, the nanopillars at the second area (Z2) having a second density, the nanopillars at the third area (Z3) having a third density, the first and second densities being lower than the third density, the first density may be identical to or different from the second density,
- a capacitive stack (30) covering the nanopillars in a conformal and continuous manner, at the first area (Z1), so as to form a capacitive area, the capacitive stack (30) comprising the insulating layer (32) and the conductive layer (33), and possibly an additional conductive layer (31) between the nanopillars and the insulating layer (32).

13. Capacitive device according to claim 12, **characterised in that** the device comprises a contact resumption at the second area (Z2), the contact resumption being formed by an additional capacitive stack covering the nanopillars at the second area (Z2) in a conformal and continuous manner, the additional capacitive stack being advantageously identical to the capacitive stack of the first area (Z1).

14. Capacitive device according to one of claims 12 and 13, **characterised in that** the insulating layer (32) completely fills the space between the nanopillars at the third area (Z3), with which an insulating area is formed between the capacitive area and the contact resumption area.

15. Capacitive device according to the preceding claim, **characterised in that** the substrate comprises a support (13) covered by a dielectric layer (12), preferably made of silicon oxide, a trench (80) being formed through the substrate (10) up to the dielectric layer (12) covering the support (13), the trench (80) forming a fourth area (Z4),
nanopillars having a fourth density filling the trench (80), the fourth density being higher than the first density and than the second density.
